**Europäisches Patentamt**

**European Patent Office**

**Office européen des brevets**

(19)

(11) Veröffentlichungsnummer : **0 153 990
B1**

(12) **EUROPÄISCHE PATENTSCHRIFT**

(45) Veröffentlichungstag der Patentschrift :
20.01.88

(51) Int. Cl.⁴ : **H 01 R 23/72, H 01 R  9/09**

(21) Anmeldenummer : **84111565.2**

(22) Anmeldetag : **27.09.84**

(54) **Flachbaugruppe.**

(30) Priorität : **30.09.83 DE 3335615**

(43) Veröffentlichungstag der Anmeldung :
**11.09.85 Patentblatt 85/37**

(45) Bekanntmachung des Hinweises auf die Patenterteilung : **20.01.88 Patentblatt 88/03**

(84) Benannte Vertragsstaaten :
**AT BE CH DE FR GB IT LI NL SE**

(56) Entgegenhaltungen :
**EP-A- 0 022 194
FR-A- 2 230 150
US-A- 4 433 892**

(73) Patentinhaber : **Siemens Aktiengesellschaft Berlin
und München
Wittelsbacherplatz 2
D-8000 München 2 (DE)**

(72) Erfinder : **Türk, Wilfried, Dipl.-Ing.
Bellinzonastrasse 16
D-8000 München 71 (DE)**
Erfinder : **Wessely, Herrmann, Dipl.-Ing.
Paul-Hösch-Strasse 1
D-8000 München 60 (DE)**

## Beschreibung

Die Erfindung bezieht sich auf eine Flachbaugruppe, bestehend aus einer mit elektrischen Bausteinen bestückten Leiterplatte mit einem Steckverbinderteil mit einer Vielzahl von Kontaktelementen.

Beim Aufbau von großen elektronischen Systemen, wie beispielsweise Datenverarbeitungsanlagen ist man bestrebt, möglichst kurze Signalleitungen mit einem definierten Wellenwiderstand zu erhalten und damit hohe Schaltgeschwindigkeiten zu erzielen. Das kann mit Hilfe von Flachbaugruppen erreicht werden, die ein- oder mehrlagige Leiterplatten mit integrierten Bausteinen aufweisen, und die über elektrische Steckverbinder mit einer Verdrahtungsplatte verbunden sind. Diese ist, um eine hohe Leiterdichte zu erreichen, ebenfalls mehrlagig ausgeführt und enthält Signalleitungen zum Verbinden von Baugruppen untereinander sowie Potential- und Versorgungsleitungen. Bei Flachbaugruppen höchster Packungsdichte sind die dazu notwendigen zahlreichen Außenanschlüsse auf engstem Raum auf der Unterseite verteilt, um die Verbindung zur Leiterplatte ohne Umwege herzustellen.

Aus der US-A-3 993 123 ist eine Flachbaugruppe mit wärmeabgebenden Bausteinen bekannt, die auf einer Seite einer Trägerplatte ankontaktiert sind. Sie liegen unter einer Kühleinrichtung, die sie wie eine Kappe umschließt, und von der aus ein oder mehrere federnde Teile ein wärmeableitendes Element auf jeden Baustein pressen. Der dabei erzeugte Druck wird auf die Plattenränder abgeleitet, die an der Kühleinrichtung angeflanscht sind, wobei der Träger jedoch eine Durchbiegung erfahren kann.

Da auch eine große Anzahl von senkrecht abstehenden Steckerstiften auf der Trägerplatte befestigt ist, beeinträchtigt eine Durchbiegung das Einstecken und Ziehen der Flachbaugruppe, was bekanntlich genau parallel zueinander ausgerichtete Stifte verbogen oder abgebrochen werden, und daß dadurch fehlerhafte Verbindungen entstehen, oder daß zumindest noch größere Steck- und Ziehkräfte aufgewendet werden müssen, als sie wegen der großen Zahl von Verbindungen ohnehin nötig sind. Außerdem besteht bei einer der mechanischen Spannung ausweichenden Leiterplatte die Gefahr, daß feine Risse in den Leiterbahnen entstehen und die Verbindungen unterbrechen. Das kann umsomehr auch dann eintreten, wenn die Stifte fest mit der Leiterplatte verbunden sind und die bereits bestehende Auslenkung bei häufigem Wechsel der Flachbaugruppe einerseits durch Ziehkräfte vergrößert und andererseits durch die Elastizität der Leiterplatte wieder zurückgestellt wird, was zu einer Ermüdung des Leiterbahnmaterials führen kann.

Es stellte sich daher die Aufgabe, eine mit einem Steckverbinderteil versehene Flachbaugruppe der oben genannten Art in der Weise auszubilden, daß aus Steck- und Ziehvorgängen resultierende Fehlerquellen verringert werden.

Diese Aufgabe wurde bei der Anordnung nach der älteren europäischen Patentanmeldung EP-A-0 105 085 (Stand der Technik gemäss Art. 54 (3) EPU) dadurch gelöst, daß auf der dem Andruckbauteil gegenüberliegenden Seite der Leiterplatte Kontaktierungsflächen gleichmäßig verteilt angeordnet sind, daß sich das Steckverbinderteil über diese gesamte Seitenfläche erstreckt, und daß es oberhalb der Kontaktierungsflächen Durchbrüche für die Kontaktelemente aufweist, die jeweils aus einem Federschaft und aus einem als Druckfeder ausgebildeten, unter Federspannung an den Kontaktierungsflächen anliegenden Anschlußfahne bestehen. Auf diese Weise wirken keine einseitigen Druckkräfte auf die Leiterplatte, so daß keine Durchbiegung auftritt. Durch die Wahl der Federkonstanten der Anschlußfahnen ist der Gegendruck auf die Leiterplatte voreinstellbar. Da außerdem die Kontaktelemente nicht starr mit der Leiterplatte verbunden sind, führen die beim Stecken und Ziehen auftretenden Kräfte nich zu einer Auslenkung der Leiterplatte. Dadurch werden Risse und Brüche in Leiterbahnen oder in Lötverbindungen, die von einer statischen oder dynamischen Krafteinwirkung herrühren, verhindert.

Wenn die Anschußfahnen gemäss der EP-A-0 105 083, als U-förmig gekrümmte Blattfedern ausgebildet sind, können sich bei sehr großer Packungsdichte und damit sehr eng liegenden Kontaktierungsflächen wegen des Platzbedarfes für die U-förmigen Blattfedern Schwierigkeiten ergeben.

Der vorliegenden Erfindung lag daher zusätzlich die Aufgabe zugrunde, eine sehr platzsparende, aber dennoch wirksame Form für die Anschlußfahnen zu schaffen.

Dies wird dadurch erreicht, daß jeweils das an der Kontaktierungsfläche anliegende Ende der Anschlußfahne als gerader Blechstreifen ausgebildet und so angeordnet ist, daß er mit seiner Stirnfläche auf die Kontaktierungsfläche drückt und daß das andere Ende über einen wellenförmig gebogenen Blattfederteil mit dem Federschaft verbunden ist.

Es ist leicht ersichtlich, daß der Platzbedarf für eine derart ausgebildete Anschlußfahne wesentlich geringer ist, als derjenige für eine im Kontaktbereich U-förmig ausgebildete Anschlußfahne.

Gemäß einer Weiterbildung ist auf der die Kontaktierungsflächen tragenden Leiterplatte eine Versteifungsplatte mit entsprechend den Kontaktierungsflächen angeordneten Löchern angeordnet und die geraden Blechstreifen der Anschlußfahnen drücken durch die Löcher hindurch auf die Kontaktierungsflächen.

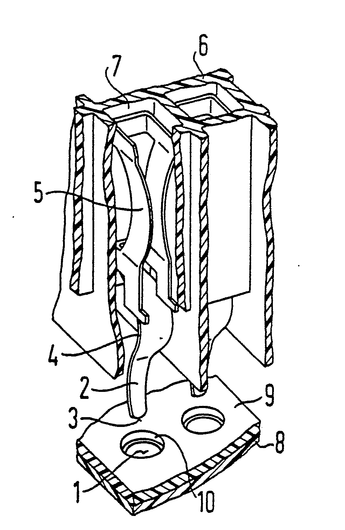

Im folgenden wird die Erfindung anhand eines in der Zeichnung dargestellten Ausführungsbeispiels weiter erläutert.

Die Zeichnung zeigt einen Ausschnitt aus der Flachbaugruppe und zwar insbesondere eine Leiterplatte 8 mit den Kontaktierungsflächen 1, ein Federgehäuse 6 mit sogenannten Federkammern 7, in denen sich die Federschäfte 5 befinden, die im dargestellten Beispiel im wesentlichen aus drei U-förmig miteinander verbundenen, einen Aufnahmekanal für einen Kontaktstift (nicht dargestellt) bildenden Seitenteilen bestehen, wobei die beiden U-Schenkel gewölbte, den Aufnahmekanal trichterförmig verengende, federnde Mittelabschnitte aufweisen. An den Federschaft 5 schließt sich die Anschlußfahne an, die erfindungsgemäß aus einem an den Federschaft unmittelbar angrenzenden wellenförmigen Blattfederteil 4 und an ihrem Ende aus einem geraden, flachen Blechstreifen 2 besteht. Dieser ist so ausgebildet und angeordnet, daß er mit seiner Stirnfläche 3 auf die Kontaktierungsfläche 1 drückt.

Gemäß einer Weiterbildung der Erfindung ist auf der Leiterplatte 8 eine Versteifungsplatte 9 angeordnet, die entsprechend den Kontaktierungsflächen 1 angeordnete Löcher 10 aufweist. Die Platte 9 hat in erster Linie die Aufgabe der Verstärkung der Leiterplatte 8, kann aber zusätzlich auch noch zur Führung der geraden Blechstreifen 2 der Anschlußfahnen dienen, die durch die Löcher 10 hindurch auf die Kontaktierungsflächen 1 drücken.

## Patentansprüche

1. Flachbaugruppe, bestehend aus einer mit elektrischen Bausteinen bestückten Leiterplatte (8), aus einem Steckverbinderteil (11) mit einer Vielzahl von Kontaktelementen (12) und aus einem, einen Druck auf eine Leiterplattenoberfläche ausübenden Andruckteil, beispielsweise einer Kühleinrichtung, wobei auf der dem Andruckbauteil gegenüberliegenden Seite der Leiterplatte (8) Kontaktierungsflächen (1) gleichmäßig verteilt angeordnet sind und sich das Steckverbinderteil (11) über diese gesamte Seitenfläche erstreckt und oberhalb der Kontaktierungsflächen (1) Durchbrüche für die Kontaktelemente (12) aufweist, die jeweils aus einem Federschaft (5) und aus einer als Druckfeder ausgebildeten, unter Federspannung an den Kontaktierungsflächen (1) anliegenden Anschlußfahne bestehen, wobei jeweils das an der Kontaktierungsfläche (1) anliegende Ende der Anschlußfahne als gerader Blechstreifen (2) ausgebildet und so angeordnet ist, daß er mit seiner Stirnflächen (3) auf die Kontaktierungsfläche (1) drückt, und daß das andere Ende über einen wellenförmig gebogenen Blattfederteil (4) mit dem Federschaft (5) des Kontaktelementes (12) verbunden ist.

2. Flachbaugruppe nach Anspruch 1, dadurch gekennzeichnet, daß auf der die Kontaktierungsflächen (1) tragenden Leiterplatte (8) eine Versteifungsplatte (9) mit entsprechend den Kontaktierungsflächen (1) angeordneten Löchern (10) angeordnet ist und die geraden Blechstreifen (2) der Anschlußfahnen durch die Löcher (10) hindurch auf die Kontaktierungsflächen (1) drücken.

## Claims

1. A flat assembly, consisting of a circuit board (8) equipped with electrical comonents, a plug connector component (11) comprising a plurality of contact elements (12), and a pressure component which exerts a pressure on a circuit board surface, for example of a cooling device, where contacting surfaces (1) are arranged so as to be uniformly distributed over that side of the circuit board (8) which lies opposite to the pressure component, and the plug connector component (11) extends over this entire side surface and above the contacting surfaces (1) contains openings for the contact elements (12), each of which consists of a spring shank (5) and a terminal lug which is in the form of a pressure spring and which abuts against the contacting surfaces (1) under spring tension, where that end of the terminal lug which abuts against the contacting surface (1) is in the form of a straight sheet metal strip (2) and is arranged in such manner that its end face (3) presses against the contacting surface (1), and that the other end is connected to the spring shank (5) of the contact element (12) via a leaf spring component (4) bent in a wave formation.

2. A flat assembly as claimed in claim 1, characterised in that a reinforcing plate (9) having holes (10) arranged to correspond to the contacting surfaces (1) is arranged on the circuit board (8) which bears the contacting surfaces (1), and that the straight sheet metal strips (2) of the terminal lugs press onto the contacting surfaces (1) through the holes (10).

## Revendications

1. Ensemble plat, constitué par une plaquette à circuits imprimés (8) garnie de composants électriques, par un élément de liaison à enfichage (11) comportant un grand nombre d'éléments de contact (12) et par un élément de pression, par exemple d'un dispositif de refroidissement, exerçant une pression sur la surface d'une plaquette à circuits imprimés, dans lequel sont prévues, sur le côté de la plaquette à circuits imprimés qui est située en face de l'élément de pression, des surfaces de contact (1) réparties uniformément, alors que l'élément de liaison à enfichage s'étend sur la totalité de ce côté et comporte, au-dessus des surfaces de contact (1) des ouvertures pour les éléments de contact (12) dont chacun est constitué par une barrette élastique (5) et par une languette de raccordement réalisée sous la forme d'un ressort de pression et portant avec tension élastique contre les surfaces de contact (1), et dans lequel chaque extrémité des languettes de raccordement, qui porte contre la surface de contact (1), est réalisée sous la forme d'une bande de tôle droite (2) et est disposée de telle manière qu'elle exerce, par sa surface frontale, une pression sur la surface de contact (1), alors que l'autre extrémité est reliée à la barrette élastique (5) de l'élément de contact (12) par l'intermédiaire d'un élément de lame de ressort (4) de forme ondulée.

2. Ensemble plat selon la revendication 1, caractérisé par le fait que sur la plaquette à circuits imprimés qui porte les surfaces de contact (1), est disposée une plaque de renforcement (9) comportant des trous (10) agencés de manière à correspondre aux surfaces de contact (1) et que les bandes de tôles droites (2) des languettes de raccordement, appuient à travers les trous (10) sur les surfaces de contact (1).